# EUROPÄISCHE PATENTSCHRIFT

(11) **EP 0 555 434 B1**
(45) Veröffentlichungstag und Bekanntmachung des Hinweises auf die Patenterteilung: **15.03.1995**
(21) Anmeldenummer: 92916927.4
(22) Anmeldetag: 14.08.1992
(51) Int. Cl.: H05K 5/06

(54) **ELEKTRISCHES GERÄT, INSBESONDERE SCHALT- UND STEUERGERÄT FÜR KRAFTFAHRZEUGE**
ELECTRICAL DEVICE, IN PARTICULAR A SWITCHING AND CONTROL DEVICE FOR MOTOR VEHICLES
APPAREIL ELECTRIQUE, EN PARTICULIER APPAREIL DE COMMUTATION ET DE COMMANDE POUR VEHICULES A MOTEUR

(30) Priorität: 03.09.1991 DE 4129238
(43) Veröffentlichungstag der Anmeldung: 18.08.1993
(73) Patentinhaber: ROBERT BOSCH GMBH, 70442 Stuttgart (DE)
(72) Erfinder: CUNTZ, Harald, W-71296 Heimsheim (DE); RAU, Martin, D-7141 Oberriexingen (DE); KARR, Dieter, D-7533 Tiefenbronn (DE)
(86) Internationale Anmeldenummer: DE9200683
(87) Internationale Veröffentlichungsnummer: WO9305635

(56) Entgegenhaltungen:
- EP-A- 0 169 329
- AT-B- 369 220
- DE-A- 2 626 328
- US-A- 4 661 888

## Beschreibung

### Stand der Technik

Die Erfindung geht aus von einem elektrischen Gerät nach der Gattung des Hauptanspruchs. Derartige bekannte Geräte haben eine Leiterplatte oder Leiterfolie, auf die eine elektronische Schaltung aufgebracht ist. Die bestückte Leiterplatte ist in einem Gehäuse untergebracht, um die Schaltung und/oder deren Bauelemente vor mechanischen Beschädigungen und den unterschiedlichen Umwelteinflüssen zu schützen. Besonders beim Einsatz derartiger Schalt- oder Steuergeräte in Kraftfahrzeugen sind die Schutzfunktionen des Gehäuses abhängig vom Einbauort und beinhalten beispielsweise den Schutz vor Feuchtigkeit, Staub und mechanischer Beschädigung. Darüber hinaus dienen diese Gehäuse oftmals auch der Abschirmung bzw. der Verbesserung der elektromagnetischen Verträglichkeit.

Um die Schaltung bzw. deren Bauelemente insbesondere gegen Staub und vor allem gegen Feuchtigkeit zu schützen, sind aufwendige Dichtungsmaßnahmen erforderlich. Dazu werden zumeist Gehäusebauteile mit Vertiefungen oder Nuten ausgestattet, in die entsprechende Dichtungen bzw. Dichtringe eingelegt werden. Darüber hinaus müssen bei derartigen Schalt- oder Steuergeräten aufwendige Druckausgleichelemente oder -maßnahmen vorgesehen sein, um durch Temperaturänderungen verursachte Druckschwankungen auszugleichen. Ein Feuchtigkeitstransport muß bei diesem Druckausgleich dennoch verhindert werden. Dadurch sind derartige Schalt- oder Steuergeräte aufwendig aufgebaut und daher teuer.

Aus der DE-A 26 26 328 ist es bekannt, die Schaltplatten in jeweils zugeordneten Fassungen anzuordnen, die dann abnehmbar an dem Gehäuse befestigt sind. Die Fassungen werden bis zu einem gewünschten Füllstand mit geeigneter Vergußmasse ausgefüllt, so daß die Schaltplatte und sämtliche ihrer elektronischen Schaltelemente abgedeckt sind. Diese Vorgehensweise ist aber relativ aufwendig und teuer. Zwar läßt sich das Eindringen von Feuchtigkeit verhindern, aber es entstehen Probleme bezüglich des Druckausgleichs.

### Vorteile der Erfindung

Das erfindungsgemäße elektrische Gerät mit den kennzeichnenden Merkmalen des Hauptanspruchs hat demgegenüber den Vorteil, daß mit einfachen und kostengünstigen Mitteln ein zuverlässiger Schutz der Leiterplatte bzw. der Leiterfolie und der Schaltungsbauelemente gegen Staub und vor allem gegen Feuchtigkeit gewährleistet ist. In einer vorteilhaften Ausgestaltung der Erfindung ist darüber hinaus ein Druckausgleich beispielsweise bei schwankenden Temperaturen möglich, der ebenfalls auf einfache und kostengünstige Weise erzielt wird.

Weitere Vorteile und vorteilhafte Weiterbildungen ergeben sich aus den Unteransprüchen und der Beschreibung.

### Zeichnung

Ein Ausführungsbeispiel der Erfindung ist in der nachfolgenden Beschreibung und Zeichnung näher erläutert. Letztere zeigt einen Längsschnitt durch ein erfindungsgemäßes elektrisches Gerät in vereinfachter Darstellung.

### Beschreibung des Ausführungsbeispiels

Das elektrische Schalt- oder Steuergerät hat eine Leiterplatte 10, auf deren Oberseite 11 eine elektronische Schaltung aufgebracht ist, von der nur einige elektronische Bauelemente 12 dargestellt sind.

Auf die Oberseite 11 der Leiterplatte 10 ist an deren vorderer Stirnseite 13 weiterhin eine an sich bekannte Steckerleiste 14 aufgesetzt, deren Anschlußfahnen 15 mit der Leiterplatte 10 bzw. der Schaltung verbunden sind.

Die Oberseite 11 der Leiterplatte 10 wird von einer haubenartigen Halbschale 16 abgedeckt, die aus einem gasdurchlässigen Kunststoff als Formteil hergestellt ist. Die Halbschale 16 hat an ihrer vorderen Seitenwand 17 eine Ausnehmung 18, die die Steckerleiste 14 umfaßt. Der übrige Bereich der vorderen Seitenwand 17 und die weiteren Seitenwände 19 haben einen durchgehenden Rand 20, der auf der Leiterplatte 10 aufliegt, ohne deren Außenrand zu erreichen. Die Abmessungen der Halbschale 16 sind so gewählt, daß die Schaltung, deren Leiterbahnen und die elektronischen Bauelemente 12 von ihr abgedeckt werden. Die Halbschale 16 ist fest mit der Leiterplatte 10 und der Steckerleiste 14 verbunden, z. B. verklebt oder verschweißt.

Die Unterseite 22 der Leiterplatte 10 ist ebenfalls von einer haubenförmigen Halbschale 23 abgedeckt, deren Seitenwände 24 einen umlaufenden Rand 25 haben, der an der Leiterplatte 10 anliegt und ebenfalls fest mit dieser verbunden ist. Die Abmessung der unteren Halbschale 23 sind so gewählt, daß einerseits der Außenrand der Leiterplatte 10 nicht erreicht wird und andererseits Leiterbahnen und Lötverbindungen der Schaltung bzw. der Bauelemente 12 abgedeckt sind.

Die obere Halbschale 16 wird von einem wannenförmigen Gehäusedeckel 27 umfaßt, der an seiner vorderen Seitenwand 28 eine die Steckerleiste 14 umfassende Ausnehmung 29 hat. Die übrigen Seitenwände 30 haben einen durchgehenden Rand 31, der auf dem äußeren Bereich der Leiterplatte 10 aufliegt.

Die untere Halbschale 23 wird von einem ebenfalls wannenförmigen Gehäuseboden 32 umfaßt, dessen vordere Seitenwand 33 an der Unterseite 34 der Steckerleiste 14 anliegt. Die übrigen Seitenwände 35 haben einen durchgehenden Rand 36, der auf dem äußeren Bereich der Unterseite 22 der Leiterplatte 10 anliegt.

Die Ränder 31 bzw. 36 von Gehäusedeckel 27 und Gehäuseboden 32 haben mehrere fluchtende Bohrungen 37, die auch die Leiterplatte 10 durchdringen, und in die Nieten 38 eingesetzt sind, die den Gehäusedeckel 27, die Leiterplatte 10 und den Gehäuseboden 32 fest miteinander verbinden.

Der durch die obere Halbschale 16 und die Leiterplatte 10 sowie die Steckerleiste 14 umschlossene Raum 40 ist über eine Bohrung 41 in der Leiterplatte 10 mit dem Raum 42 verbunden. Dieser Raum 42 wird durch die untere Halbschale 23 und die Leiterplatte 10 gebildet.

Die obere Halbschale 16 und die untere Halbschale 23 sind als Kunststofformteile aus einem wasserundurchlässigen, aber gasdurchlässigen, Kunststoff hergestellt und feuchtigkeitsdicht mit der Leiterplatte verbunden. Dafür geeignete Kunststoffe sind beispielsweise Polyamid, Polyester, Polypropylen. Die Halbschalen 16 bzw. 23 sind feuchtigkeitsdicht mit der Leiterplatte verbunden, so daß die Räume 42 und 40 und damit die Schaltung und deren Bauelemente 12 vor Nässe geschützt sind. Der Gehäusedeckel 27 und der Gehäuseboden 32 dienen dem Schutz gegen mechanische Beschädigungen und schützen sowohl Leiterplatte 10 und Bauelemente 12 als auch die Halbschalen 16 und 23. Der Gehäuseboden 32 und der Gehäusedeckel 27 brauchen jedoch keinerlei Dichtfunktionen übernehmen, so daß auf aufwendige Dichtnuten und Dichtringe verzichtet werden kann. Durch die Wahl eines gasdurchlässigen Kunststoffes für die Halbschalen 16 und 23 ist ein Druckausgleich zwischen den Räumen 40 und 42 einerseits und der Umgebung andererseits gewährleistet. Druckschwankungen bei Temperaturänderungen können somit ausgeglichen werden, ohne daß ein Feuchtigkeitstransport ins Innere der Räume 40, 42 erfolgt. Über die Bohrungen 41 sind die beiden Räume 40 und 42 verbunden, so daß in beiden gleicher Druck herrscht.

Es ist auch möglich, nur einen Teil einer Halbschale 16 oder 23 gasdurchlässig auszubilden, um einen Druckausgleich zu gewährleisten. Dazu sind beispielsweise beide Halbschalen aus einem wasser- und gasundurchlässigen Kunststoff gefertigt, und eine der beiden Halbschalen hat eine fensterartige Öffnung, die durch einen gasdurchlässigen Kunststoff in Form einer Membran abgedeckt ist. Eine derartige Kunststoffmembran kann beispielsweise aus PTFE hergestellt sein. Diese Membran wird dann mechanisch und gegen Strahlwasser bzw. Spritzwasser durch das Gehäuse (Gehäusedeckel 27 und Gehäuseboden 32) geschützt und bedarf im Gegensatz zu herkömmlichen Lösungen keiner zusätzlichen Teile.

Werden Gehäusedeckel 27 und Gehäuseboden 32 aus Metall gefertigt, um beispielsweise Abschirmfunktionen zu erfüllen, können die Halbschalen 16 und 23 auch Isolierfunktionen übernehmen. Dazu werden dann beispielsweise die Ränder 20 und 25 so ausgebildet, daß sie den Bereich zwischen den Rändern 31 bzw. 36 von Gehäusedeckel 27 bzw. Gehäuseboden 32 einerseits und Leiterplatte 10 andererseits abdecken, und damit isolieren.

Werden Gehäusedeckel 27 und Gehäuseboden 32 nicht aus Metall gefertigt, so können die Halbschalen 16 und 23 Abschirmfunktionen übernehmen. Dazu werden diese partiell oder vollständig mit einer metallischen bzw. elektrisch leitenden Beschichtung vorgesehen, die elektrisch leitend mit der Leiterplatte verbunden ist. Es ist auch möglich, die Halbschalen (16, 23) vollständig aus einem elektrisch leitenden, gasdurchlässigen und feuchtigkeitsundurchlässigen Material herzustellen.

Durch die Trennung der Funktionen Schutz gegen mechanische Belastung und Feuchteschutz können für jede der beiden Funktionen optimale und kostengünstige Lösungen eingesetzt werden. Gehäusedeckel 27 und Gehäuseboden 32 haben keine Dichtfunktionen, so daß aufwendige Dichtkonturen entfallen. Dadurch sind einfache Konstruktionen möglich.

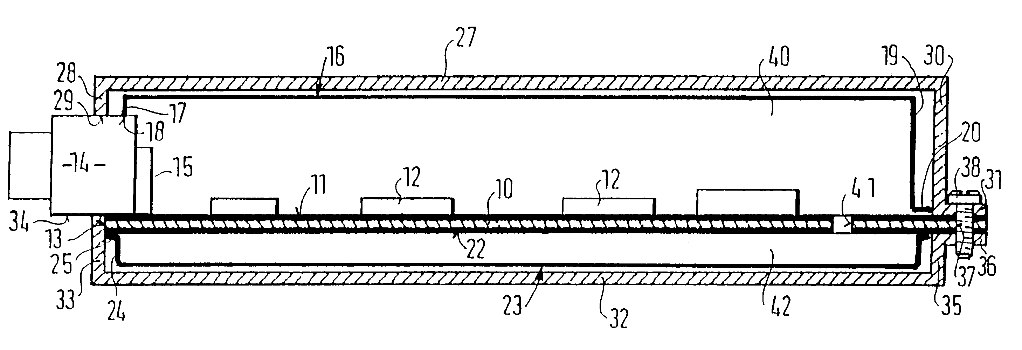

## Patentansprüche

1. Elektrisches Gerät, insbesondere Schalt- und Steuergerät für Kraftfahrzeuge, mit einem Gehäuse (27, 32), in dem mindestens eine Leiterplatte (10) angeordnet ist, die eine elektronische Schaltung trägt, dadurch gekennzeichnet, daß die Schaltung durch mindestens eine innerhalb des Gehäuses angeordnete, zusätzliche Abdeckung (16, 32) gegen Feuchtigkeit geschützt ist, wobei die Abdeckung feuchtigkeitsundurchlässig, aber mindestens teilweise gasdurchlässig ist.

2. Elektrisches Gerät nach Anspruch 1, dadurch gekennzeichnet, daß die Oberseite (11) und die Unterseite (22) der Leiterplatte (10) durch je eine zusätzliche Abdeckung (16, 23) abgedeckt sind und daß sämtliche Leiterbahnen und elektronischen Bauelemente (12) der Schaltung jeweils unter einer der Abdeckungen liegen.

3. Elektrisches Gerät nach Anspruch 1 oder 2, dadurch gekennzeichnet, daß die Abdeckung aus einem feuchtigkeitsundurchlässigen Kunststoff besteht.

4. Elektrisches Gerät nach einem der Ansprüche 1 bis 3, dadurch gekennzeichnet, daß die Abdeckung (16, 23) aus Kunststofformteilen besteht, die feuchtigkeitsdicht mit der Leiterplatte (10) verbunden sind.

5. Elektrisches Gerät nach einem der Ansprüche 1 bis 4, dadurch gekennzeichnet, daß die Abdeckung zumindestens teilweise luftdurchlässig ist.

6. Elektrisches Gerät nach einem der Ansprüche 1 bis 5, dadurch gekennzeichnet, daß die Oberseite (11) und die Unterseite (22) der Leiterplatte durch einen Kanal (41) verbunden sind.

7. Elektrisches Gerät nach einem der Ansprüche 1 bis 6, dadurch gekennzeichnet, daß das Gehäuse (27, 32) zumindest teilweise metallisch ist, und daß die zusätzliche Abdeckung als Isolation zwischen Gehäuse und Leiterplatte (10) wirkt.

8. Elektrisches Gerät nach einem der Ansprüche 1 bis 7, dadurch gekennzeichnet, daß das Gehäuse (27, 32) aus mindestens zwei Teilen besteht.

9. Elektrisches Gerät nach einem der Ansprüche 1 bis 8, dadurch gekennzeichnet, daß die Schaltung mit einer Steckerleiste (14) versehen ist, die auf der Leiterplatte (10) angebracht ist, und die zumindestens teilweise von der Abdeckung (16, 23) umfaßt ist.

10. Elektrisches Gerät nach einem der Ansprüche 1 bis 9, dadurch gekennzeichnet, daß die zusätzliche Abdeckung (16, 23) zumindest partiell elektrisch leitend beschichtet ist.

11. Elektrisches Gerät nach Anspruch 10, dadurch gekennzeichnet, daß die elektrisch leitende Beschichtung elektrisch leitend mit der Leiterplatte (10) verbunden ist.

12. Elektrisches Gerät nach einem der Ansprüche 1 bis 11, dadurch gekennzeichnet, daß die Abdeckung (16, 23) elektrisch leitend ist.

## Claims

1. Electrical apparatus, especially a switching apparatus and controller for motor vehicles, having a housing (27, 32) in which at least one printed circuit board (10) is arranged which is fitted with an electronic circuit, characterized in that the circuit is protected against moisture by means of at least one additional cover (16, 32) which is arranged inside the housing, the cover being impermeable to moisture but at least partially permeable to gas.

2. Electrical apparatus according to Claim 1, characterized in that the top (11) and the bottom (22) of the printed circuit board (10) are covered by in each case one additional cover (16, 23), and in that all the conductor tracks and electronic components (12) of the circuit are in each case located under one of the covers.

3. Electrical apparatus according to Claim 1 or 2, characterized in that the cover consists of a plastic which is impermeable to moisture.

4. Electrical apparatus according to one of Claims 1 to 3, characterized in that the cover (16, 23) consists of plastic mouldings which are connected to the printed circuit board (10) in a moisture-proof manner.

5. Electrical apparatus according to one of Claims 1 to 4, characterized in that the cover is at least partially permeable to air.

6. Electrical apparatus according to one of Claims 1 to 5, characterized in that the top (11) and the bottom (22) of the printed circuit board are connected by means of a channel (41).

7. Electrical apparatus according to one of Claims 1 to 6, characterized in that the housing (27, 32) is at least partially metallic, and in that the additional cover acts as insulation between the housing and the printed circuit board (10).

8. Electrical apparatus according to one of Claims 1 to 7, characterized in that the housing (27, 32) consists of at least two parts.

9. Electrical apparatus according to one of Claims 1 to 8, characterized in that the circuit is provided with a plug strip (14) which is fitted on the printed circuit board (10) and is at least partially surrounded by the cover (16, 23).

10. Electrical apparatus according to one of Claims 1 to 9, characterized in that the additional cover (16, 23) is coated such that it is at least partially electrically conductive.

11. Electrical apparatus according to Claim 10, characterized in that the electrically conductive coating is electrically conductively connected to the printed circuit board (10).

12. Electrical apparatus according to one of Claims 1 to 11, characterized in that the cover (16, 23) is electrically conductive.

## Revendications

1. Appareil électrique, en particulier appareil de commutation et de commande pour véhicules à moteur, avec un carter (27, 32) dans lequel est disposé au moins une plaquette de circuit imprimé (10) qui porte un circuit électronique, appareil électrique caractérisé en ce que le circuit est protégé par au moins un revêtement (16, 32) additionnel, disposé à l'intérieur du boîtier, contre l'humidité, le revêtement étant imperméable à l'humidité, mais perméable aux gaz au moins en partie.

2. Appareil électrique selon la revendication 1, caractérisé en ce que la face supérieure (11) et la face inférieure (22) de la plaquette de circuit imprimé (10) sont recouvertes chacune par un revêtement additionnel (16, 23) et en ce que toutes les pistes conductrices et les composants (12) du circit sont placés recpectivement sous un revêtement de protection.

3. Appareil électrique selon la revendication 1 ou 2, caractérisé en ce que le revêtement consiste en une matière plastique imperméable à l'humidité.

4. Appareil électrique selon l'une des revendications 1 à 3, caractérisé en ce que le revêtement (16, 23) consiste en des pièces moulées en matière plastique qui sont reliées à la plaquette de circuit imprimé (10) de façon étanche à l'humidité.

5. Appareil électrique selon l'une des revendications 1 à 4, caractérisé en ce que le revêtement est au moins en partie perméable à l'air.

6. Appareil électrique selon l'une des revendications 1 à 5, caractérisé en ce que la face supérieure (11) et la face inférieure (22) de la plaquette de circuit imprimé sont reliées par un canal (41).

7. Appareil électrique selon l'une des revendications 1 à 6, caractérisé en ce que le boîtier (27, 32) est au moins en partie métallique et en ce que le revêtementadditionnel sert d'isolation entre le boîtier et la plaquette de circuit imprimé (10).

8. Appareil électrique selon l'une des revendications 1 à 7, caractérisé en ce que le boîtier (27, 32) consiste au moins en deux parties.

9. Appareil électrique selon l'une des revendications 1 à 8, caractérisé en ce que le circuit est pourvu d'une barrette d'enfichage (14) qui est mise sur la plaquette de circuit imprimé (10) et qui est entourée au moins en partie par le revêtement(16, 23).

10. Appareil électrique selon l'une des revendications 1 à 9, caractérisé en ce que le revêtementadditionnel (16, 23) est au moins en partie électriquement conducteur.

11. Appareil électrique selon la revendication 10, caractérisé en ce que le revêtement électriquement conducteur est relié de façon électriquement conductrice à la plaquette de circuit imprimé (10).

12. Appareil électrique selon l'une des revendications 1 à 11, caractérisé en ce que le revêtement (16, 23) est électriquement conducteur.
